# EUROPÄISCHE PATENTSCHRIFT

(11) **EP 4 441 514 B1**
(45) Veröffentlichungstag und Bekanntmachung des Hinweises auf die Patenterteilung: **09.07.2025**
(21) Anmeldenummer: 23805525.5
(22) Anmeldetag: 09.11.2023
(51) Int. Cl.: G01R 31/367, B60L 58/16, G01R 31/382, G01R 31/389, G01R 31/392, G01R 31/396, H01M 10/48

(54) **VERFAHREN ZUR MODELLBASIERTEN ABSCHÄTZUNG DER IMPEDANZ EINER GALVANISCHEN ZELLE EINER SEKUNDÄRBATTERIE UND DESSEN VERWENDUNG SOWIE BATTERIEZELLENÜBERWACHUNGSVORRICHTUNG UND FAHRZEUG**
METHOD FOR THE MODEL-BASED ESTIMATION OF THE IMPEDANCE OF A GALVANIC CELL OF A SECONDARY BATTERY, AND USE THEREOF, AND BATTERY CELL MONITORING DEVICE, AND VEHICLE
PROCÉDÉ D'ESTIMATION, BASÉE SUR UN MODÈLE, DE L'IMPÉDANCE D'UNE CELLULE GALVANIQUE D'UNE BATTERIE SECONDAIRE, ET SON UTILISATION, ET DISPOSITIF DE SURVEILLANCE DE CELLULE DE BATTERIE, ET VÉHICULE

(30) Priorität: 19.12.2022 DE 102022004803
(43) Veröffentlichungstag der Anmeldung: 09.10.2024
(73) Patentinhaber: Mercedes-Benz Group AG, 70372 Stuttgart (DE)
(72) Erfinder: BENSAAD, Yassine, 70563 Stuttgart (DE); FRIEDRICHS, Fabian, 70569 Stuttgart (DE); BAUMHÖFER, Thorsten, 75428 Illingen (DE); BÄHR, Judith, 72622 Nürtingen (DE)
(74) Vertreter: Novagraaf Group
(86) Internationale Anmeldenummer: PCT/EP2023/081302
(87) Internationale Veröffentlichungsnummer: WO 2024/132289

(56) Entgegenhaltungen:
- CN-B- 106 918 789
- DE-A1- 102019 127 384
- GB-A- 2 532 726
- FARMANN ALEXANDER ET AL: "Adaptive approach for on-board impedance parameters and voltage estimation of lithium-ion batteries in electric vehicles", JOURNAL OF POWER SOURCES, ELSEVIER, AMSTERDAM, NL, vol. 299, 9 September 2015 (2015-09-09), pages 176 - 188, XP029297357, ISSN: 0378-7753, DOI: 10.1016/J.JPOWSOUR.2015.08.087
- FLEISCHER CHRISTIAN ET AL: "On-line adaptive battery impedance parameter and state estimation considering physical principles in reduced order equivalent circuit battery models Part 1. Requirements, critical review of methods and modeling", JOURNAL OF POWER SOURCES, ELSEVIER, AMSTERDAM, NL, vol. 260, 5 March 2014 (2014-03-05), pages 276 - 291, XP028847790, ISSN: 0378-7753, DOI: 10.1016/J.JPOWSOUR.2014.01.129
- FLEISCHER CHRISTIAN ET AL: "On-line adaptive battery impedance parameter and state estimation considering physical principles in reduced order equivalent circuit battery models part 2. Parameter and state estimation", JOURNAL OF POWER SOURCES, ELSEVIER, AMSTERDAM, NL, vol. 262, 27 March 2014 (2014-03-27), pages 457 - 482, XP029025943, ISSN: 0378-7753, DOI: 10.1016/J.JPOWSOUR.2014.03.046
- WYCISK DOMINIK ET AL: "Modified Plett-model for modeling voltage hysteresis in lithium-ion cells", JOURNAL OF ENERGY STORAGE, ELSEVIER BV, NL, vol. 52, 14 June 2022 (2022-06-14), XP087102807, ISSN: 2352-152X, [retrieved on 20220614], DOI: 10.1016/J.EST.2022.105016

## Beschreibung

Die Erfindung betrifft ein Verfahren zur modellbasierten Abschätzung der Impedanz einer galvanischen Zelle einer Sekundärbatterie mittels eines auf einer Recheneinheit ausgeführten Abschätzungsmodells nach der im Oberbegriff von Anspruch 1 näher definierten Art, eine Batteriezellenüberwachungsvorrichtung nach der im Oberbegriff von Anspruch 6 näher definierten Art, die Verwendung besagten Verfahrens zur Bestimmung der Lebensdauer von Batteriezellen einer Traktionsbatterie eines Fahrzeugs nach der im Anspruch 7 näher definierten Art sowie ein Fahrzeug nach der im Oberbegriff von Anspruch 8 näher definierten Art.

Aufgrund ihrer hohen Energie- und Leistungsdichte sind Lithium-Ionen-Batterien für die Entwicklung und im Betrieb von Elektromobilitätskonzepten in Elektrofahrzeugen unerlässlich. Ein Batteriemanagementsystem (BMS) steuert die in mobilen Anwendungen eingesetzten Batteriepakete und gewährleistet deren optimale Leistung.

Eine genaue Abschätzung des Gesundheitszustands, auch als State-of-Health (SOH) bezeichnet ist für die Betriebssicherheit von Elektrofahrzeugen entscheidend. Der Anstieg des Innenwiderstands, auch als State-of-Health-Resistance (SOHR) bezeichnet, im Laufe der Alterung gilt als eine der wichtigsten Degradationserscheinungen, die die Leistung und Lebensdauer von Batteriezellen einschränken. Darüber hinaus ist der Innenwiderstand für die thermische Analyse der Zelle und die Temperaturüberwachung von wesentlicher Bedeutung. Der Innenwiederstand einer Zelle hängt stark von der Temperatur und dem Ladezustand, auch als State-of-Charge (SOC) bezeichnet, ab.

Die genaue Prognose des Zellinnenwiderstands verhindert unnötig groß dimensionierte Ausfallreserven in der Batterieauslegung und -nutzung und ermöglicht somit das Ausschöpfen der tatsächlichen Leistungs- und Lebensdauergrenzen im realen Betrieb. Ein frühzeitiger und unnötiger Batterietausch wird folglich verhindert und somit das Maß an Nachhaltigkeit von Elektrofahrzeugen deutlich erhöht.

Die Impedanz, also den Wechselstromwiderstand von Batteriezellen, lässt sich mit Hilfe der elektrochemischen Impedanzspektroskopie messen. Dies ist jedoch aufgrund der erforderlichen Messtechnik und dem durchzuführenden Aufwand vergleichsweise teuer und zeitintensiv. Das Messen der Impedanz von Batteriezellen im Fahrzeug ist somit impraktikabel.

Stattdessen wird der Impedanzverlauf der Batteriezellen einer Traktionsbatterie eines Fahrzeugs mit Hilfe von Rechenmodellen im laufenden Betrieb abgeschätzt. Grundlage eines solchen Rechenmodells stellt ein elektrisches Ersatzmodell der Batterie dar, welches wiederum auf einem elektronischen Ersatzschaltbild aufbaut. Dabei unterliegen die in einem solchen Ersatzschaltbild enthaltenen Komponenten wie Widerstände, Spulen, Kondensatoren und dergleichen Alterungseffekten gleichermaßen, welche sich auf die Impedanz ausüben. Um eine realitätsnahe Impedanz berechnen zu können gilt es also über die Lebensdauer die Parameter dieser Elektronikkomponenten unter Berücksichtigung der Alterung korrekt abzuschätzen.

So offenbart die DE 10 2019 127 384 A1 ein Verfahren zur Parameterschätzung in einem Impedanz-Modell einer Lithium-Ionen-Zelle. Die mittels Messung aufgefundenen Parameter werden zur Anwendung durch ein Rechenmodell zur Bestimmung der Impedanz in eine Recheneinheit eines Fahrzeugs implementiert. Die Messungen werden dabei im Fahrzeug durchgeführt.

Eine umfangreiche Übersicht über gängige Methoden zur Batterieparameterabschätzung ist auch aus Y: C. Fleischer, W. Waag, H.-M. Heyn, and D. U. Sauer. On-line adaptive battery impedance parameter and state estimation considering physical principles in reduced order equivalent circuit battery models: Part 1. requirements, critical review of methods and modeling. Journal of Power Sources, 260:276-291, 2014 bekannt. Die Autoren stellen zudem ein selbstentwickeltes Abschätzungsmodell vor, welches zusammen mit den Berechnungsergebnissen und einer Bewertung der Vorhersagegenauigkeit in einem zweiten Paper beschrieben wird. Siehe hierzu Y: C. Fleischer, W. Waag, H.-M. Heyn, and D. U. Sauer. On-line adaptive battery impedance parameter and state estimation considering physical principles in reduced order equivalent circuit battery models part 2. parameter and state estimation. Journal of Power Sources, 262:457-482, 2014.

Zum Auffinden relevanter Modellparameter wird dabei Online im Fahrzeug während dessen Betrieb ein rechenaufwändiges Optimierungsproblem geschlossener Form gelöst. Hierzu wird ein rekursiver Schätzer auf Basis der Methode der kleinsten Quadrate eingesetzt. Dies ist nur möglich wegen der Linearität des vereinfachten Rechenmodells, da die Rechenressourcen im Fahrzeug begrenzt sind, das Lösen eines Optimierungsproblems rechen- und zeitaufwändig ist und somit eine Lösung in vertretbarer Zeit im Fahrzeug sonst nicht erhalten werden kann. Dabei wird die Temperaturabhängigkeit der Modelparameter on-board mitgeschätzt. Das Abschätzen der Temperaturabhängigkeit verschlechtert die Vorhersagegüte. Zudem wird ein rechenaufwändiger iterativer Mutationsalgorithmus zum Abschätzen der Stromabhängigkeit verwendet.

Der vorliegenden Erfindung liegt die Aufgabe zugrunde ein verbessertes Verfahren zur modellbasierten Abschätzung der Impedanz einer galvanischen Zelle einer Sekundärbatterie anzugeben, welches sich für die Anwendung in Fahrzeugen während deren Betrieb eignet und dabei eine gesteigerte Vorhersagegüte aufweist.

Erfindungsgemäß wird diese Aufgabe durch ein Verfahren zur modellbasierten Abschätzung der Impedanz einer galvanischen Zelle einer Sekundärbatterie mit den Merkmalen des Anspruchs 1 gelöst. Vorteilhafte Ausgestaltungen und Weiterbildungen sowie die Verwendung eines solchen Verfahrens zur Bestimmung der Lebensdauer von Batteriezellen einer Traktionsbatterie eines Fahrzeugs, eine Batteriezellenüberwachungsvorrichtung zur Durchführung des Verfahrens sowie ein Fahrzeug mit einer solchen Batteriezellenüberwachungsvorrichtung ergeben sich aus den hiervon abhängigen Ansprüchen.

Ein gattungsgemäßes Verfahren zur modellbasierten Abschätzung der Impedanz einer galvanischen Zelle einer Sekundärbatterie mittels eines auf einer Recheneinheit ausgeführten Abschätzungsmodells, wobei zumindest einige der Modellparameter eines Ersatzschaltbilds der Zelle in einem im Abschätzungsmodell enthaltenen Zellmodell über die Lebensdauer der Zelle angepasst werden, wobei das Ersatzschaltbild zumindest ein Widerstandselement und ein Kapazitätselement umfasst, wird erfindungsgemäß dadurch weitergebildet, dass die folgenden Verfahrensschritte vor der eigentlichen Nutzung der Zelle durchgeführt werden:
- initiales Parametrieren des Zellmodells basierend auf Messreihen elektrochemischer Impedanzspektroskopie einer baugleichen Zelle;
- Erzeugen einer Referenzdatenbank, umfassend eine Zuordnung aus Modellparameter-Referenzwerten und korrespondierenden Impedanz-Referenzwerten über ein Lebensdauerkennfeld der baugleichen Zelle, durch:
   - Aufprägen einer Vielzahl von temperaturspezifischen Lade- und Entladeprofile, jeweils umfassend einen Spannungsverlauf der Zelle über der Zeit, auf das Abschätzungsmodell;
   - dabei Nachführen der anzupassenden Modellparameter des Ersatzschaltbilds mittels eines nichtlinearen Optimierers, wobei eine Differenz zwischen gemessener und durch das Zellmodell berechneter Zellspannung gebildet und minimiert wird, wobei in respektiven Minima aufgefundene Modellparameter zur Ausbildung der Modellparameter-Referenzwerte verwendet werden; und
   - Berechnen der zu den Modellparameter-Referenzwerten korrespondierenden Impedanz-Referenzwerten;
- Fitten eines jeweiligen Modellparameter-Referenzwerts aus der Referenzdatenbank mittels Polynom-Fit und abspeichern der dabei ermittelten Fitting-Koeffizienten in einem Datenspeicher;
sowie die folgenden Verfahrensschritte während der eigentlichen Nutzung der Zelle durchgeführt werden:
- Ermitteln der Differenz aus einer gemessenen Zellspannung und einer mittels des Zellmodells berechneten Zellspannung;
- Festlegen eines Verstärkungsfaktors und Multiplizieren der im vorigen Verfahrensschritt ermittelten Spannungsdifferenz mit dem Verstärkungsfaktor; und
- inkrementelle Bestimmung der Impedanz der Zelle, wobei das nächste Inkrement der Impedanz berechnet wird durch hinzuaddieren des aktuellen Inkrements der Impedanz zum im vorigen Verfahrensschritt errechneten Produkt aus Verstärkungsfaktor und Spannungsdifferenz, wobei anschließend die veränderbaren Modellparameter unter Berücksichtigung der Fitting-Koeffizienten dem so berechneten nächsten Inkrement der Impedanz nachgeführt werden.

Das erfindungsgemäße Verfahren erlaubt eine besonders genaue und damit zuverlässige Abschätzung der Impedanz von Batteriezellen und weist dabei einen vergleichsweise geringen Rechenbedarf auf. Das Verfahren eignet sich somit besonders zur Anwendung im laufenden Betrieb eines Fahrzeugs. So muss im Fahrzeug selbst keine Optimierung durchgeführt werden, um die auf den jeweiligen Betriebszustand der Batterie passenden Modellparameter zu ermitteln. Stattdessen werden diese Modellparameter initial in einem Labor oder einem Testfahrzeug, also off-board eines Serienfahrzeugs, abgeschätzt und mit Hilfe von Fitting für alle möglichen Zustände ermittelt. Diese Referenzwerte werden dann für den jeweiligen tatsächlichen Anwendungsfall im (Serien-)Fahrzeug herangezogen. Die zur Berechnung der Impedanz betrachtete Spannungsdifferenz zwischen gemessener und abgeschätzter Klemmspannung wird dabei zu jeder Abtastperiode ausgewertet, was eine besonders zeitlich hochaufgelöste Betrachtung erlaubt.

Das erfindungsgemäße Verfahren sieht vor, Offline bzw. off-board, also nicht im Betrieb des Fahrzeugs selbst, sondern beispielsweise in einem Labor oder Testfahrzeug Erkenntnisse über die Veränderungen des elektrischen Zellverhaltens über ihre Lebensdauer zu sammeln. Dieses Zellverhalten ist typisch für Zellen eines bestimmten Bautyps und lässt sich somit auf baugleiche Zellen übertragen. Die vor der eigentlichen Nutzung der Zelle durchgeführten Verfahrensschritte können somit an einer beliebigen baugleichen Zelle in einem Labor durchgeführt werden und die während der eigentlichen Nutzung der Zelle durchgeführten Verfahrensschritte an einer hierzu abweichenden Sekundärbatterie mit entsprechenden baugleichen Zellen. Die Sekundärbatterie kann dabei als Spannungsquelle in einer beliebigen Maschine wie einem Fahrzeug eingesetzt werden, um diese zu betreiben.

Der Aufbau eines Ersatzschaltbilds einer Zelle und dessen Implementierung in eine Recheneinheit sind gängige Praxis. Es stellt sich jedoch die Frage, wie alterungsabhängige Modellparameter über die Lebensdauer der Sekundärbatterie an ihre physikalisch korrekten Werte angepasst werden können. Für den betrachteten Zelltyp wird hierzu eine vollständige Parametrierung des Abschätzungsmodells bzw. des Ersatzschaltbilds und damit des elektrischen Teils des Zellmodells basierend auf elektrochemische Impedanzspektroskopiemessungen (EIS-Messungen) einer fabrikneuen Zelle durchgeführt, wodurch das physikalische Verhalten dieser "beginning-of-life" (BOL) Zelle vergleichsweise physikalisch korrekt wiedergegeben wird. Das physikalische Verhalten der Zelle ist dabei von der Temperatur und dem Ladezustand abhängig. Das Durchführen der EIS-Messungen sieht vor, verschiedene Messreihen zu unterschiedlichen Ladezuständen zwischen 0 und 100% sowie Temperaturen beispielsweise zwischen -20° C und +45° C durchzuführen. Temperaturabhängigkeiten werden auf Basis von Arrhenius-Funktionen gefittet. Arrhenius-Funktionen beschreiben das Verhältnis zwischen Reaktionskinetiken in der Batteriezelle zu jeweiligen Temperaturen. Die so aufgefundenen Arrhenius-Funktionen werden gespeichert und fest in das Abschätzungsmodell für den späteren Einsatz integriert. Die Abhängigkeiten zu unterschiedlichen Ladezuständen werden in Form von Faktoren aus Look-Up-Tabellen im Abschätzungsmodell hinterlegt. Neben der Temperaturabhängigkeit bleibt also auch die Abhängigkeit zu verschiedenen Ladezuständen (SOC) über die Lebensdauer der galvanischen Zelle konstant.

Die EIS-Messungen können dabei an einer oder mehreren Einzelzellen durchgeführt werden oder auch an verschiedenen zu einem Batteriemodul zusammengefügten Zellen.

Im nächsten Schritt gilt es nun die für diese fabrikneue Zelle bzw. Zellen (BOL-Zellen) aufgefundene "Start"-Parametrierung über dessen Lebensdauer anzupassen. Um den Verlauf sämtlicher relevanten Modellparameter, die über die Zellalterung geänderte Werte annehmen, aufzufinden, wird das Abschätzungsmodell in eine Batteriezellenüberwachungsvorrichtung eingebracht. Eine solche Batteriezellenüberwachungsvorrichtung umfasst Erfassungsmittel zum Erfassen des von wenigstens einer Zelle der Sekundärbatterie abgebbaren Stroms, der Klemmspannung und der Batterietemperatur an einer beliebigen Stelle, insbesondere die Zelltemperatur der überwachten Zelle. Ferner umfasst die Batteriezellenüberwachungsvorrichtung einen Datenspeicher sowie eine Recheneinheit, auf der das Abschätzungsmodell implementiert wird. Nun wird eine bereits gealterte Sekundärbatterie, umfassend eine Vielzahl baugleicher Zellen, herangezogen und auf diese Sekundärbatterie emulierte, simulierte oder real erfahrene Entlade- und Ladeprofile aufgeprägt.

Solche Entlade- und Ladeprofile können beispielsweise mit Testfahrten mit einem Fahrzeug generiert werden. Ein Entladen erfolgt so beispielsweise während der Fahrt mit dem Fahrzeug während eines längeren Zeitraums wie zwei Stunden. Dabei kann das Fahrzeug auch einen entsprechenden Elektromotor im Generatormodus betreiben und somit aufgrund von Rekuperation elektrische Energie zum Laden der Batteriezellen in die Sekundärbatterie einspeisen. Entsprechende Ladevorgänge dauern dabei vergleichsweise kurz und liegen in einer Größenordnung von mehreren Sekunden. Bei einem Ladeprofil handelt es sich um beispielsweise einen an einer Ladestation real durchgeführten Ladevorgang. Beispielsweise wird die Sekundärbatterie dabei von einem Ladezustand von 20% auf einen Ladezustand von 85% innerhalb mehrerer Minuten, beispielsweise 40 Minuten, aufgeladen. Das Aufprägen der Entlade- und Ladeprofile kann im Fahrzeug selbst erfolgen oder auch bei einer ausgebauten Traktionsbatterie, die auf einem Prüfstand installiert ist. Auf diesem Prüfstand werden dann die real erfahrenen, simulierten bzw. emulierten Entlade- und Ladeprofile aufgeprägt.

Jede Zelle der Sekundärbatterie weist über fortschreitende Lebensdauer einen unterschiedlichen Alterungszustand auf. Entsprechend weisen die einzelnen Batteriezellen der betrachteten Traktionsbatterie eine unterschiedliche Impedanz auf. Mit Hilfe des Abschätzungsmodells und den gemessenen Größen wird dann die Referenzdatenbank aufgebaut. Die über die Lebensdauer und entsprechend Alterung variablen Modellparameter werden dabei mit Hilfe eines nicht linearen Optimierers bestimmt. Hierzu vergleicht das Abschätzungsmodell den gemessenen und den abgeschätzten Spannungswert und minimiert diesen solange, bis die Abweichung minimal, idealerweise Null, ist. In den respektiven Minima aufgefundene Modellparameter dienen dann zur Ausbildung der Modellparameter-Referenzwerte. Hierbei handelt es sich um konkrete Werte (entsprechend der durchgeführten Messreihen). Im späteren Betrieb eines Fahrzeugs werden die Zellen jedoch typischerweise beliebige Impedanzwerte annehmen, welche so in diesen Messreihen nicht zwangsweise enthalten sind. Um dennoch für diese Impedanzwerte Modellparameter in die Referenzdatenbank aufzunehmen, werden für jeden Modellparameter Fitting-Funktionen bestimmt, die einem Verlauf des variablen Modellparameters über der Impedanz entsprechen. Hierzu werden gängige Polynom-Fit-Methoden verwendet. Es können Polynome n-ter Ordnung verwendet werden. Die Verwendung von Polynomen zweiter Ordnung, also quadratische Funktionen, hat sich dabei jedoch als besonders vorteilhaft erwiesen, da dies ein gutes Verhältnis aus Genauigkeit zu Rechenaufwand darstellt.

Somit liegt eine Wissensbasis vor, welche Ausprägung ein jeweiliger alterungsspezifischer Modellparameter über einen jeweiligen Impedanzwert annimmt. Dies ist ein Kerngedanke der Erfindung, da somit die rechenintensive Optimierung aus den Fahrzeugen ins Labor bzw. ein Testfahrzeug ausgelagert und für jeden unterschiedlichen Zelltyp nur einmalig ausgeführt werden muss.

Die dabei errechneten Fitting-Koeffizienten werden in einem Datenspeicher abgelegt. Der Datenspeicher ist Teil der Recheneinrichtung bzw. eines Prüfstands. Aus dem Datenspeicher lassen sich die Fitting-Koeffizienten an beliebigere weitere Recheneinheiten verteilen und dort implementieren. Beispielsweise handelt es sich dabei um das Batteriemanagementsystem einer Traktionsbatterie eines Fahrzeugs.

Das Abschätzungsmodell kann dann im laufenden Betrieb eines Fahrzeugs zum Abschätzen der Impedanz der Batteriezellen der Traktionsbatterie des Fahrzeugs eingesetzt werden. Dies ermöglicht die Abschätzung der Impedanz der Zellen der Traktionsbatterie des Fahrzeugs während dessen Betrieb. Hierzu wird das Abschätzungsmodell in die Recheneinheit eines Fahrzeugs implementiert, beispielsweise in eine separate Recheneinheit, das BMS oder eine Batteriezellenüberwachungsvorrichtung oder dergleichen.

Eine vorteilhafte Weiterbildung des erfindungsgemäßen Verfahrens sieht vor, dass das Ersatzschaltbild der Zelle zumindest ein zusätzliches der folgenden weiteren Elemente enthält:
- ein ZARC-Element;
- ein Spulenelement;
- ein Finite-Length-Warburg-Element; und/oder
- ein Finite-Space-Warburg-Element.

Indem in das Ersatzschaltbild der Zelle durch besagte Elemente ergänzt wird, lässt sich ein besonders realitätsgenaues Ersatzschaltbild und damit elektrisches Zellmodell erzeugen. Hierdurch werden die physikalischen Prozesse der einzelnen Zellen bestmöglich mathematisch beschrieben. Ein einzelner Widerstand repräsentiert dabei den elektrischen Widerstand leitenden Materials, wie die Ableiter an den Elektroden, Kabel innerhalb der Batterie und die begrenzte Leitfähigkeit des Elektrolyts.

Eine Spule kann zum Repräsentieren induktiven Verhaltens in das Ersatzschaltbild inkludiert werden. Induktives Verhalten tritt aufgrund metallischer Kontakte innerhalb der Zelle auf.

Ein ZARC-Element besteht aus einem Ohm'schen Widerstand, der zu einer Kapazität parallelgeschaltet ist. Ein ZARC-Element bildet den Effekt von Doppelschichten und Ladungstransfer ab. Dies erlaubt es nichtlineare Spannungsabhängigkeiten zu berücksichtigen. Mit ZARC-Elementen lässt sich der hochfrequente Teil der Zellimpedanzen beschreiben.

Der niederfrequente Teil der Zellimpedanzen lässt sich mit Hilfe von Warburg-Elementen beschreiben. So erfassen Warburg-Elemente Vorgänge, die die vergleichsweise langsame Ionendiffusion innerhalb der Elektroden beschreiben. Ein Finite-Space-Warburg-Element repräsentiert eine nicht konduktive Grenzschicht bei einer maximalen Diffusionslänge, wohingegen ein Finite-Length-Warburg-Element eine perfekte konduktive Grenzschicht bei maximaler Diffusionslänge beschreibt.

Entsprechend einer weiteren vorteilhaften Ausgestaltung des Verfahrens wird die Spannungsdifferenz der gemessenen Zellspannung und der berechneten Zellspannung vor der Multiplikation mit dem Verstärkungsfaktor tiefpassgefiltert. Dies stabilisiert die Parameternachführung der Modellparameter und ermöglicht es kurzzeitig auftretende Modellfehler möglichst von Parametereinlernfehlern zu unterscheiden.

Eine weitere vorteilhafte Ausgestaltung des Verfahrens sieht ferner vor, dass das Zellmodell zur Berechnung der Zellspannung jeweils einen Term für die Überspannung, die Hysteresespannung und die Leerlaufspannung berücksichtigt. Dabei wird die Leerlaufspannung durch den gewichteten Mittelwert der tiefpassgefilterten Differenz der Klemm- und Überspannung und der durch Stromintegration gerechneten Leerlaufspannung approximiert. Die Hysteresespannung wird beispielsweise gemäß des modifizierten Plett-Modells, präsentiert von D. Wycisk, M. Oldenburger, M. G. Stoye, T. Mrkonjic, and A. Latz. Modified plett-model for modeling voltage hysteresis in lithium-ion cells. Journal of Energy Storage, 52:105016, 2022 durch ein paralleles Softwaremodul bereitgestellt. Die Leerlaufspannung wird approximiert durch gewichtete Mittelwerte zweier unterschiedlicher Spannungsschätzungen. Die erste Spannungsschätzung ergibt sich aus der tiefpassgefilterten Differenz der Klemmspannung und der Überspannung und die zweite Schätzung aus der durch Stromintegration gerechneten Leerlaufspannung.

Entsprechend einer weiteren vorteilhaften Ausgestaltung des erfindungsgemäßen Verfahrens wird der Verstärkungsfaktor in Abhängigkeit folgender vier Terme bestimmt:
- ein Grundverstärkungsterm;
- ein Batteriestromvorzeichenterm;
- ein Potenzterm des Absolutwerts des Zellstroms; und
- ein exponentieller Abklingterm.

Der Verstärkungsfaktor kann größer, kleiner oder gleich 1 sein sowie positive oder negative Werte annehmen.

Mit Hilfe des Batteriestromvorzeichenterms lässt sich berücksichtigen, ob die Zelle gerade geladen oder entladen wird.

Der Potenzterm des Absolutwerts des Zellstroms steuert die Größenordnung der Zellüberspannung mit dem geringsten restlichen Fehler. Höher Werte induzieren eine bessere Übereinstimmung bei hohen Überspannungen und mehr Fehlertoleranz bei niedrigen Überspannungen und umgekehrt.

Der exponentielle Abklingterm erlaubt ein schnelleres Einlernen der Modellparameter nach einem Parameterzurücksetzen. Dabei kann eine Abklingkonstante eingesetzt werden, welche das Einlernen zurückgesetzter Parameter beschleunigt. Der Term kann zudem einen Faktor enthalten, der ein verlangsamtes Einlernen unmittelbar nach dem Aufwachen eines Steuergeräts erlaubt, bis die Spannung an RC-Gliedern des Modells durch dynamisches Laden und Entladen eingelernt ist.

Bei einer Batteriezellenüberwachungsvorrichtung, umfassend Erfassungsmittel zum Erfassen des von wenigstens einer Zelle einer Sekundärbatterie abgebbaren Stroms, der Klemmspannung und einer Batterietemperatur von Zellen sowie ein Datenspeicher und eine Recheneinheit sind erfindungsgemäß die Erfassungsmittel, der Datenspeicher und die Recheneinheit zur Ausführung der während der eigentlichen Nutzung der Zelle durchgeführten Verfahrensschritte eines im vorigen beschriebenen Verfahrens eingerichtet. Die Batteriezellenüberwachungsvorrichtung kann Teil eines Batteriemanagementsystems sein oder ein solches ausbilden. Als Erfassungsmittel kann die Batteriezellenüberwachungsvorrichtung Stromsensoren, Spannungssensoren sowie Temperatursensoren umfassen oder an diese anschließbar sein. Bei dem Datenspeicher handelt es sich um nichtflüchtigen Speicher, gegebenenfalls ergänzt durch flüchtigen Speicher. Bei der Recheneinheit handelt es sich um einen Computer, ein System-on-a-Chip (SoC) oder dergleichen. Der Datenspeicher kann in die Recheneinheit integriert sein.

Ein im vorigen beschriebenes Verfahren wird erfindungsgemäß dazu verwendet die Lebensdauer von Batteriezellen einer Traktionsbatterie eines Fahrzeugs mit einem zumindest teilelektrifizierten Antriebsstrang zu bestimmen, wobei die während der eigentlichen Nutzung der Zelle durchgeführten Verfahrensschritte im Fahrzeug durchgeführt werden. Wie bereits erwähnt lässt sich mit Hilfe des erfindungsgemäßen Verfahrens besonders genau und damit besonders zuverlässig der Alterungszustand von Batteriezellen einer Traktionsbatterie des Fahrzeugs abschätzen. Dieser ist gleichbedeutend mit der Impedanz der jeweiligen Zellen. Bei der Zelle kann es sich beispielsweise um eine Lithium-Ionen-Zelle handeln. Das erfindungsgemäße Verfahren kommt jedoch auch für Batteriezellen unterschiedlichen Typs in Frage wie beispielsweise Natrium-Ionen-Zellen.

Bei einem Fahrzeug mit einem zumindest teilelektrifizierten Antriebsstrang, umfassend eine Traktionsbatterie und eine Batteriezellenalterungsbestimmungsvorrichtung, weist erfindungsgemäß die Batteriezellenalterungsbestimmungsvorrichtung eine im vorigen beschriebene Batteriezellenüberwachungsvorrichtung auf. Bei der Batteriezellenalterungsbestimmungsvorrichtung kann es sich um eine der Batteriezellenüberwachungsvorrichtung übergeordnete Recheneinheit handeln. Die Batteriezellenüberwachungsvorrichtung kann auch integraler Bestandteil der Batteriezellenalterungsbestimmungsvorrichtung sein. Beispielsweise kann es sich bei der Batteriezellenalterungsbestimmungsvorrichtung um ein Batteriemanagementsystem handeln, in welches die Batteriezellenüberwachungsvorrichtung integriert ist.

Weitere vorteilhafte Ausgestaltungen des erfindungsgemäßen Verfahrens zur modellbasierten Abschätzung der Impedanz einer galvanischen Zelle einer Sekundärbatterie ergeben sich auch aus den Ausführungsbeispielen, welche nachfolgend unter Bezugnahme auf die Figuren näher beschrieben werden.

Dabei zeigen:
- Fig. 1: eine schematisierte Darstellung einer erfindungsgemäßen Batteriezellenüberwachungsvorrichtung;
- Fig. 2: eine schematisierte Darstellung eines in einem Zellmodell eines auf der in Fig. 1 gezeigten Batteriezellenüberwachungsvorrichtung ausgeführten Abschätzungsmodell implementierten Ersatzschaltbilds einer Zelle und die dazugehörigen Impedanzspektra;
- Fig. 3: ein Diagramm, zeigend den Verlauf eines Modellparameters eines im Ersatzschaltbild enthaltenen Bauelements über der Impedanz der Zelle;
- Fig. 4: einen Gleichungssatz der im Abschätzungsmodell hinterlegten Gleichungen; und
- Fig. 5: ein Ablaufdiagramm eines erfindungsgemäßen Verfahrens zum Abschätzen der Impedanz einer galvanischen Zelle einer Sekundärbatterie.

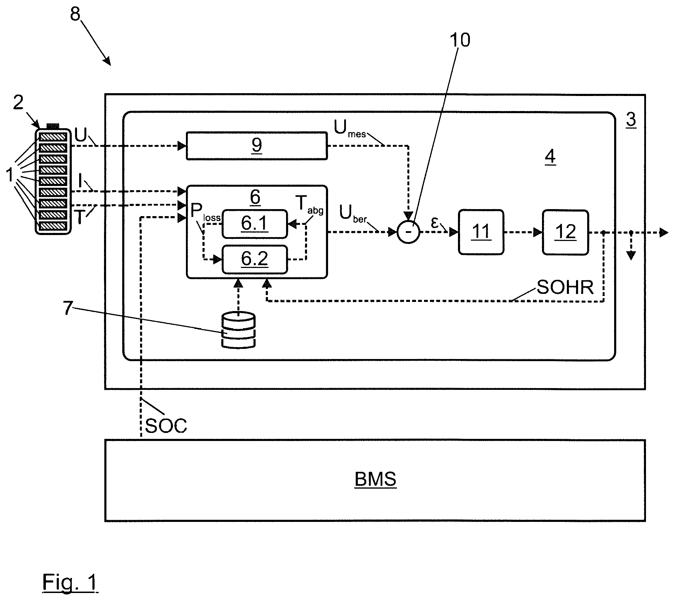

Eine in Figur 1 gezeigte Batteriezellenüberwachungsvorrichtung 8 umfasst eine Recheneinheit 3, die zur Ausführung eines Abschätzungsmodells 4 dient. Mit Hilfe der Batteriezellenüberwachungsvorrichtung 8 werden die Zellen 1 einer Sekundärbatterie 2 überwacht, um deren alterungsabhängige Impedanz über die Lebensdauer der Sekundärbatterie 2 abzuschätzen. Mit Hilfe der abgeschätzten Impedanz lässt sich eine Aussage über die Alterung der Sekundärbatterie 2 machen.

Es kann für jede Zelle 1 der Sekundärbatterie 2 eine eigene Batteriezellenüberwachungsvorrichtung 8 vorgesehen sein oder aber mit ein und derselben Batteriezellenüberwachungsvorrichtung 8 lassen sich mehrere Zellen 1 überwachen. Als Eingangsgrößen dienen dem Abschätzungsmodell 4 der durch eine jeweilige Zelle 1 fließende Strom I, die Klemmspannung U, auch als gemessene Spannung Uₘₑₛ bezeichnet, eine Temperatur T der Sekundärbatterie 2, bevorzugt der zu überwachenden Zelle 1 sowie der rechnerisch abgeschätzte Ladezustand SOC der jeweiligen Zelle 1. Der Ladezustand SOC kann durch übliche Methoden bereitgestellt werden, beispielsweise ermittelt durch ein Batteriemanagementsystem BMS. Das Batteriemanagementsystem BMS kann Teil der Recheneinheit 3 sein oder, wie dargestellt, separat hierzu ausgeführt sein.

Das Abschätzungsmodell 4 kann ein Phasenanpassungsmodul 9 zum Anpassen der Phase der gemessenen Spannung Uₘₑₛ aufweisen. Das Zellmodell 6 weist ein elektrisches Zellmodell 6.1 und ein thermisches Zellmodell 6.2 auf. Das elektrische Zellmodell 6.1 gibt als Ausgangsgröße einen Widerstand der betrachteten Zelle 1 aus, bzw. eine Verlustleistung Pₗₒₛₛ und das thermische Zellmodell 6.2 die Temperatur T_{abg} der jeweiligen Zelle 1. Ferner weist das Abschätzungsmodell 4 eine Referenzdatenbank 7 auf, in der die Entwicklung von im elektrischen Zellmodell 6.1 eines Ersatzschaltbilds umfassten Modellparameter über die Lebensdauer enthalten sind.

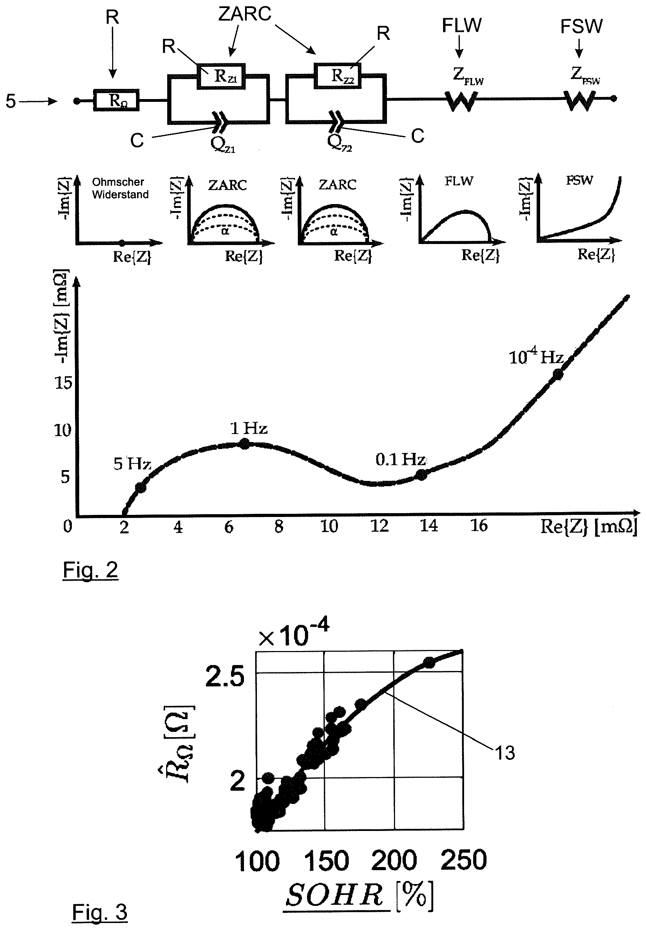

Mit Hilfe des Zellmodells 6 wird eine berechnete Spannung U_{ber} berechnet. Die gemessene Spannung Uₘₑₛ und die berechnete Spannung U_{ber} werden in einem Subtrahierer 10 zusammengeführt und voneinander abgezogen, um eine Differenz aus diesen Größen zu bestimmen. Die Differenz, hier als Fehler ε bezeichnet, gilt es zu minimieren. So beträgt der Fehler ε 0, wenn die von der Lebensdauer der Zelle 1 abhängigen Modellparameter des in Figur 2 gezeigten Ersatzschaltbilds 5 bzw. des elektrischen Zellmodells 6.1 den realen physikalischen Werten entsprechen. Der Fehler ε kann optional durch ein Filtermodul 11 zum Glätten, beispielsweise mittels Tiefpass, geleitet werden. Anschließend wird er in ein Regelsystem 12 eingespeist, beispielsweise ein PID-Regler. Als Ergebnis liefert das Regelsystem 12 den gesuchten Alterungszustand der Zelle 1 in Form des abgeschätzten Innenwiderstands, also der Impedanz. Die Impedanz wird auch als State-of-Health-Resistance SOHR bezeichnet. Die Impedanz wird im Abschätzungsmodell 4 rückgeführt und dient als Eingangsgröße für das Zellmodell 6. Ebenfalls lässt sich die Impedanz aus dem Abschätzungsmodell 4 und sogar aus der Recheneinheit 3 ausleiten, um als Eingangsgröße für weitere Rechenmodelle bereitzustehen, beispielsweise als Eingangsgröße für ein Fahrerassistenzsystem.

Der hier gezeigte Aufbau des Abschätzungsmodells 4 sieht eine iterative, also inkrementelle Berechnung der Impedanz vor. Das aktuelle rückgeführte Inkrement der Impedanz dient somit zum Berechnen des nächsten Inkrements.

Figur 2 zeigt den Aufbau des elektrischen Ersatzschaltbilds 5 einer jeweiligen Zelle 1. Dieses umfasst ein Widerstandselement R sowie zwei aufeinanderfolgende ZARC-Elemente ZARC gefolgt von zwei aufeinanderfolgenden Warburg-Elementen. Es handelt sich hierbei um ein Finites-Space-Warburg-Element FSW und ein Finite-Length-Warburg-Element FLW. Ein ZARC-Element wiederum umfasst ein parallel zu einem Widerstandselement R geschaltetes Kapazitätselement C.

Unter dem Ersatzschaltbild 5 sind in Figur 2 ferner die Impedanzspektren der jeweiligen Elemente sowie das Impedanzspektrum des vollständigen Modells gezeigt. Dabei sind auf der Abszisse jeweils der Realteil und auf der Ordinate der Imaginärteil der Impedanz in Ohm aufgetragen.

Für eine schnelle und recheneffiziente Ausführung des Abschätzungsmodells 4 im Fahrzeug wird ein Zusammenhang benötigt der beschreibt, welche Ausprägung ein jeweiliger Modellparameter des Ersatzschaltbilds 5 in Abhängigkeit des Alterungszustands der Zelle 1, also der Impedanz bzw. der State-Of-Health-Resistance SOHR, annimmt. Diese Zusammenhänge sind in der in Figur 1 gezeigten Referenzdatenbank 7 abgespeichert.

Figur 3 veranschaulicht den Prozess zur Gewinnung der in der Referenzdatenbank 7 hinterlegten Informationen anhand eines Diagramms. Das bereitgestellte Rechenmodell wird in einer Testumgebung zur Analyse einer realen Batterie eingesetzt. Die reale Batterie enthält unterschiedlich gealterte Zellen 1. Das Rechenmodell ist vorparametrisiert basierend auf einer EIS-Messung einer fabrikneuen Zelle. Nun gilt es den Verlauf der Modellparameter über die Impedanz zu bestimmen. Beispielhaft ist in Figur 3 der Verlauf für den Einzelwiderstand R gezeigt. Hierzu werden reale, simulierte oder emulierte Entladungs- und Ladeprofile auf eine gealterte Sekundärbatterie 2 aufgeprägt, beispielsweise in einem Labor, auf einem Prüfstand, bzw. in einem Testfahrzeug. Zur Bestimmung des Verlaufs der einzelnen Modellparameter über der Impedanz bzw. über der State-Of-Health-Resistance SOHR dient ein Optimierungsalgorithmus. Der Optimierungsalgorithmus hat die Aufgabe, den Fehler ε im Abschätzungsmodell 4 zu minimieren. Dabei werden die jeweiligen Ausprägungen der Modellparameter geändert. Somit werden für jede untersuchte Zelle 1 zu jedem Messpunkt im Kennfeld der jeweiligen Entlade- und Ladeprofile für die einzelnen Zellen 1 der Batterie korrespondierende Modellparameter erhalten (schwarze Kreise im Diagramm).

Da jedoch im realen Betrieb Werte für sämtliche Impedanzwerte erforderlich sind, also ein kontinuierlicher Verlauf und nicht nur an den Stellen an denen sich im Diagramm schwarze Kreise befinden, wird ein Fitting durchgeführt, wodurch die Ausgleichskurve 13 erhalten wird. Die zum Bestimmen der Ausgleichskurve 13 ermittelten Fitting-Koeffizienten werden dann in der Referenzdatenbank 7 hinterlegt. Somit ist es möglich für sämtliche Ausprägungen der Impedanz, also State-Of-Health-Resistance SOHR passende Modellparameterwerte zu ermitteln. Es muss dann auf der Recheneinheit 3, also im jeweiligen Fahrzeug im späteren Betrieb, nicht erneut eine Optimierung durchgeführt werden, was in erheblichem Maße Rechenaufwand spart und somit eine besonders zeitlich schnelle Ausführung des erfindungsgemäßen Verfahrens und somit Berechnung der Impedanz ermöglicht.

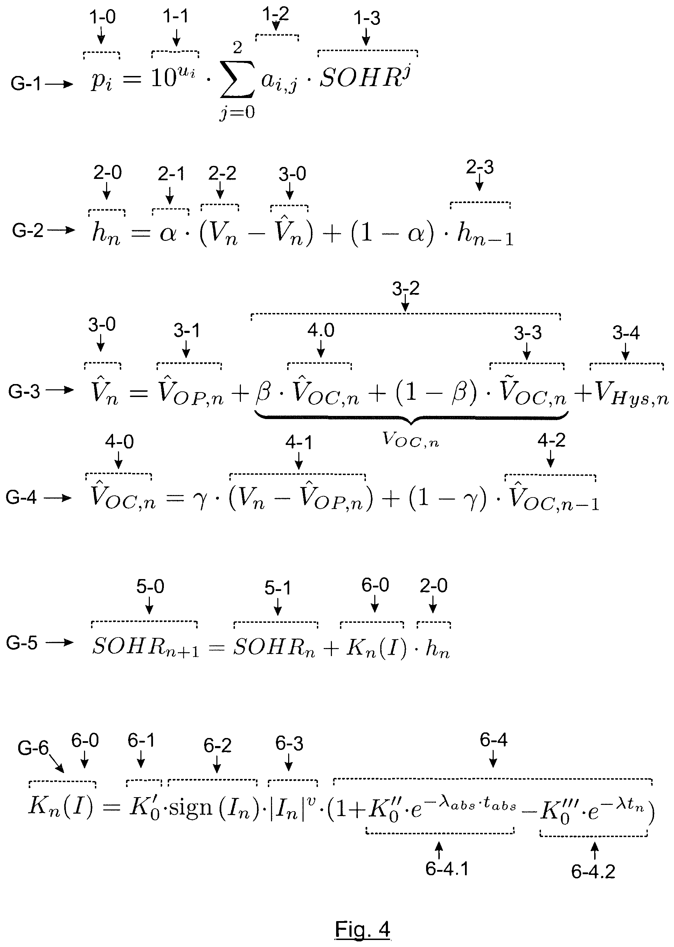

Figur 4 zeigt einen Satz Gleichungen, wie er im Rechenmodell hinterlegt sein kann.

Gleichung eins G-1 beschreibt die Formel zur Definition unterschiedlicher Modellparameter. Der Term 1-0 repräsentiert einen jeweiligen Modellparameter. Der Term 1-1 beschreibt die jeweilige Größenordnung des Modellparameters und dient dazu, alle Modellparameter auf dieselbe Größenordnung zu skalieren. Der Term 1-2 beschreibt einen Koeffizienten. Der Term 1-3 repräsentiert die eigentliche Impedanz. Die Impedanz weist die Potenz j auf. Idealerweise beträgt j=2. Dies stellt einen Kompromiss zwischen einer ausreichend schnellen Berechnung und einem ausreichend genauen Ergebnis dar. Es handelt sich dann um ein quadratisches Polynom.

Gleichung zwei G-2 dient zur Beschreibung der Spannungsdifferenz im Subtrahierer 10. Der Term 2-0 beschreibt die Spannungsdifferenz zwischen der gemessenen und der berechneten Spannung Uₘₑₛ und U_{ber}. Der Index "n" referenziert dabei das aktuelle Inkrement, bzw. Iteration. So wird während eines Abtast- bzw. Berechnungsschritts mehrfach iteriert. Der Term 2-1 beschreibt eine Filterkonstante, die einen Wert zwischen 0 und 1 annehmen kann, wobei gilt, dass Alpha sehr viel kleiner als 1 ist. Der Term 2-2 entspricht der gemessenen Spannung Uₘₑₛ zum aktuellen Inkrement und der Term 3-0 entspricht der berechneten Spannung U_{ber} zum aktuellen Inkrement. Der Term 2-4 entspricht der Spannungsdifferenz zum vorherigen Inkrement "n-1".

Gleichung drei G-3 dient zur Beschreibung berechneten Spannung U_{ber}. Der Term 3-1 entspricht der Überspannung. Der Term 3-2 entspricht der Leerlaufspannung. Der Term 3-4 entspricht der Hysteresespannung. Der Term 4-0 entspricht der tiefpassgefilterten Differenz der Klemm- und Überspannung und der Term 3-3 entspricht der durch Stromintegration gerechneten Leerlaufspannung. Bei der Größe Beta handelt es sich um eine Gewichtungs- und Filterkonstante, die eine Ausprägung zwischen 0 und 1 annehmen kann.

Gleichung vier G-4 beschreibt die Berechnung des Terms 4-0. Der Term 4-1 beschreibt die Differenz zwischen gemessener Spannung Uₘₑₛ und Überspannung. Der Term 4-2 beschreibt dem Term 4-0 zum vorigen Inkrement.

Gleichung fünf G-5 dient zur Beschreibung der Impedanz, also der State-Of-Health-Resistance SOHR im nächsten Inkrement "n+1". Der Term 5-0 entspricht der Impedanz der Zelle 1. Dieser setzt sich zusammen aus dem Term 5-1, also der Impedanz zum jetzigen Inkrement "n" plus dem Produkt aus den beiden Termen 6-0 und 2-0, wobei der Term 6-0 einem Verstärkungsfaktor entspricht und der Term 2-0 besagter Spannungsdifferenz.

Gleichung sechs G-6 gibt die Rechenvorschrift zur Bestimmung des Verstärkungsfaktors an. Der Term 6-1 bezeichnet eine Grundverstärkung für die Rückführung der Spannungsdifferenz. Der Term 6-2 beschreibt das Vorzeichen des Batteriestroms. Der Term 6-3 beschreibt einen Potenzterm des Absolutwerts des Zellstroms und steuert die Größenordnung der Zellüberspannung mit dem geringsten restlichen Fehler. Die Größe v kann eine Ausprägung zwischen 0 und 1 annehmen. Höhere v-Werte induzieren eine bessere Übereinstimmung bei hohen Überspannungen und mehr Fehlertoleranz bei niedrigen Überspannungen und umgekehrt. Der Term 6-4 beschreibt einen exponentiellen Abklingterm. Der Term 6-4.1 erlaubt ein um K₀"-faches schnelles Einlernen der Parameter zur Zeit t_{abs} nach einem Parameterzurücksetzen. Die abklingende Konstante λ bestimmt dabei die zeitliche Abklingrate dieser zusätzlichen Verstärkung, um das Einlernen zurückgesetzter Parameter zu beschleunigen. Der Term 6-4.2 erlaubt ein um K₀"'-faches verlangsamtes Einlernen unmittelbar nach dem Aufwachen der Recheneinheit 3, bis die Spannung an RC-Gliedern des Modells durch dynamisches Laden und Entladen eingelernt ist.

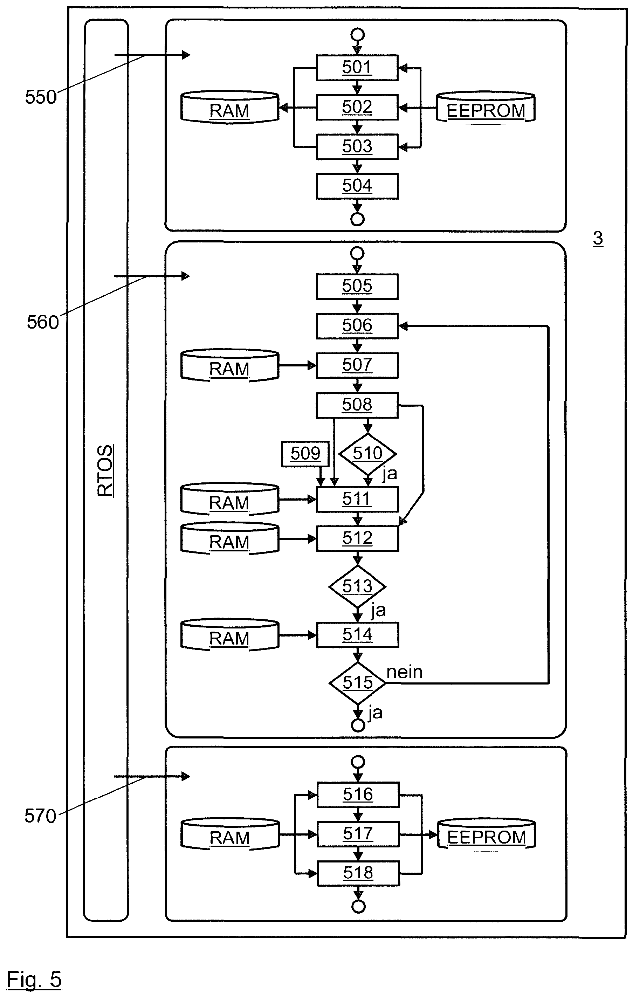

Figur 5 zeigt eine Implementierung des Abschätzungsmodells 4 auf einem eingebetteten System in Form eines Ablaufdiagramms zu Ausführung der in einem Fahrzeug ablaufenden Verfahrensschritte des erfindungsgemäßen Verfahrens. Das eingebettete System wird von der Recheneinheit 3 ausgebildet, welche somit ein zeitdiskretes Steuergerät darstellt. Bevorzugt handelt es sich um eine Fix-Point Implementierung, welcher eine gesteigerte Leistungsfähigkeit bei reduziertem Speicherverbrauch im Vergleich zu Floating-Point Implementierungen auf eingebetteten Systemen aufweist. In Figur 5 kann es sich bevorzugt bei der Recheneinheit 3 um das Batteriemanagementsystem des Fahrzeugs handeln. Die Tick-Rate des Batteriemanagementsystems ist beispielsweise auf eine Frequenz von 50 Hertz gesetzt.

Ein Echtzeitbetriebssystem RTOS der Recheneinheit 3 führt einen Initialisierungsaufruf 550 aus, angestoßen durch ein Initialisierungsevent, woraufhin das Zellmodell 6 initialisiert wird. Hierzu werden während der letzten Laufzeit, also vor einem Herunterfahren der Recheneinheit 3 gespeicherte Werte für die Modellparameter und entsprechenden Spannungen aus einem nichtflüchtigen Speicher EEPROM ausgelesen, welche daraufhin in einen flüchtigen Speicher RAM geschrieben werden. Im Verfahrensschritt 501 werden die alterungsabhängigen Modellparameterverläufe aus der Referenzdatenbank 7 ausgelesen. Im Verfahrensschritt 502 werden die zuletzt verarbeiteten Spannungswerte ausgelesen. Im Verfahrensschritt 503 werden Spannungsverteilungen für die RC-Elemente des Zellmodells 6 ausgelesen. Im Verfahrensschritt 504 werden die RC-Spannungen, bevor die Recheneinheit 4 in den Schlafmodus gegangen ist, neu berechnet.

Anschließend führt die Recheneinheit 3 bzw. das Echtzeitbetriebssystem RTOS im Verfahrensschritt 560 einen Zyklusaufruf der lauffähigen Hauptfunktion des Abschätzungsmodells 4 durch. Im Verfahrensschritt 505 werden die gemessene Zellspannung, der Strom und die abgeschätzte Zelltemperatur erfasst. Gegebenenfalls wird dabei eine Phasenadaption der gemessenen Spannungswerte durchgeführt, um den Strom- und die Spannungssignale zu synchronisieren. Die folgenden Verfahrensschritte 506 bis 515 können für mehrere, bevorzugt sämtliche Zellen 1 der Sekundärbatterie 2 seriell durchgeführt werden. Hierzu können die Verfahrensschritte 506 bis 515 beispielsweise als FOR-Schleife implementiert sein, wobei über die einzelnen Zellen 1 iteriert wird. Dabei wird im Verfahrensschritt 506 ein Zelliterator gezählt.

Im Verfahrensschritt 507 werden die alterungsabhängigen Modellparameter für die aktuelle Impedanz berechnet, wobei die in den flüchtigen Speicher RAM geschriebenen Werte aus der Referenzdatenbank 7 verarbeitet werden.

Dabei wird der Zusammenhang zu den bereits erwähnten Arrhenius-Gleichungen und Temperatur berücksichtigt. Dies erfolgt im Verfahrensschritt 508 zusammen mit einem Berechnungsschritt zum Berücksichtigen des Ladungszustands SOC. Im Verfahrensschritt 509 wird die Schlafdauer der Recheneinheit 3 ausgelesen und an das Modell übergeben. Dies wird nach einem Neustart benötigt, um im Verfahrensschritt 511 die Spannungswerte der RC-Elemente zu bestimmen. Hierzu werden die entsprechenden Spannungswerte vor dem Schlafenlegen der Recheneinheit 3 benötigt, die aus dem flüchtigen Speicher RAM ausgelesen werden. Ob es sich an dieser Stelle um die Initialisierung nach dem Aufwachen der Recheneinheit 3 handelt, wird im Verfahrensschritt 510 geprüft.

Im Verfahrensschritt 512 wird eine vorwärtsgerichtete Berechnung durchgeführt, um als Ausgangssignale die Klemmspannung, die Zellspannung und thermischen Verluste zu berechnen. Über die Rückführung der Spannungswerte wird der berücksichtigte Alterungsfaktor, also die Impedanz, nachverfolgt. Der nachgeführte Alterungsfaktor, also die berechnete Impedanz zum nächsten Inkrement, wird zurückgeführt, um die Modellparameterberechnung anzupassen. Im Verfahrensschritt 513 wird geprüft, ob der Strom über einem Strommindestwert liegt und die Änderung des Stroms dabei über einem korrespondierenden Grenzwert für die Stromänderung liegt. Ist dies der Fall, wird im Verfahrensschritt 514 die Impedanz nachgeführt und in den flüchtigen Speicher RAM geschrieben. Im Verfahrensschritt 515 wird geprüft, ob es sich um die letzte zu überwachende Zelle 1 handelt.

Im Verfahrensschritt 570 stößt das Echtzeitbetriebssystem RTOS eine Herunterfahrsequenz an. Hierzu werden im Verfahrensschritt 516 die Spannungen der Warburg-Elemente und die aktuellen Modellparameter (also die entsprechend der Alterung angepassten Modellparameter) in den flüchtigen Speicher EEPROM für jede Zelle 1 geschrieben. Im Verfahrensschritt 517 werden analog die Spannungsverteilungen einzelner Warburg-Elemente zu RC-Spannungen in den nichtflüchtigen Speicher EEPROM geschrieben, jedoch nur für eine einzige Zelle 1. Im Verfahrensschritt 518 werden die Impedanzen der einzelnen Zellen 1, also die Alterungsfaktoren, gespeichert. Damit endet das Verfahren.

## Patentansprüche

1. Verfahren zur modellbasierten Abschätzung der Impedanz einer galvanischen Zelle (1) einer Sekundärbatterie (2) mittels eines auf einer Recheneinheit (3) ausgeführten Abschätzungsmodells (4), wobei zumindest einige der Modellparameter eines Ersatzschaltbilds (5) der Zelle (1) in einem im Abschätzungsmodell (4) enthaltenen Zellmodell (6) über die Lebensdauer der Zelle (1) angepasst werden, wobei das Ersatzschaltbild (5) zumindest ein Widerstandselement (R) und ein Kapazitätselement (C) umfasst,
**gekennzeichnet durch**
die folgenden vor der eigentlichen Nutzung der Zelle (1) durchgeführten Verfahrensschritte:
- Initiales Parametrieren des Zellmodells (6) basierend auf Messreihen elektrochemischer Impedanzspektroskopie einer baugleichen Zelle (1);
- Erzeugen einer Referenzdatenbank (7), umfassend eine Zuordnung aus Modellparameter-Referenzwerten und korrespondierenden Impedanz-Referenzwerten über ein Lebensdauerkennfeld der baugleichen Zelle (1), **durch**:
∘ Aufprägen einer Vielzahl von temperaturspezifischen Lade- und Entladeprofile, jeweils umfassend einen Spannungsverlauf der Zelle (1) über der Zeit, auf das Abschätzungsmodell (4);
∘ dabei Nachführen der anzupassenden Modellparameter des Ersatzschaltbilds (5) mittels eines nichtlinearen Optimierers, wobei eine Differenz zwischen gemessener und **durch** das Zellmodell (6) berechneter Zellspannung (Uₘₑₛ, U_{rec}) gebildet und minimiert wird, wobei in respektiven Minima aufgefundene Modellparameter zur Ausbildung der Modellparameter-Referenzwerte verwendet werden; und
∘ Berechnen der zu den Modellparameter-Referenzwerten korrespondierenden Impedanz-Referenzwerten;
- Fitten eines jeweiligen Modellparameter-Referenzwerts aus der Referenzdatenbank (7) mittels Polynom-Fit und abspeichern der dabei ermittelten Fitting-Koeffizienten in einem Datenspeicher;
sowie die folgenden während der eigentlichen Nutzung der Zelle (1) durchgeführten Verfahrensschritte:
- Ermitteln der Differenz aus einer gemessenen Zellspannung (Uₘₑₛ) und einer mittels des Zellmodells (6) berechneten Zellspannung (U_{rec});
- Festlegen eines Verstärkungsfaktors und multiplizieren der im vorigen Verfahrensschritt ermittelten Spannungsdifferenz mit dem Verstärkungsfaktor; und
- Inkrementelle Bestimmung der Impedanz der Zelle (1), wobei das nächste Inkrement der Impedanz berechnet wird **durch** hinzuaddieren des aktuellen Inkrements der Impedanz zum im vorigen Verfahrensschritt errechneten Produkt aus Verstärkungsfaktor und Spannungsdifferenz, wobei anschließend die veränderbaren Modellparameter unter Berücksichtigung der Fitting-Koeffizienten dem so berechneten nächsten Inkrement der Impedanz nachgeführt werden.

2. Verfahren nach Anspruch 1,
**dadurch gekennzeichnet, dass**
das Ersatzschaltbild (5) der Zelle (1) zumindest ein zusätzliches der folgenden weiteren Elemente enthält:
- ein ZARC-Element (ZARC);
- ein Spulenelement;
- ein Finite-Length-Warburg-Element (FLW); und/oder
- ein Finite-Space-Warburg-Element (FSW).

3. Verfahren nach Anspruch 1 oder 2,
**dadurch gekennzeichnet, dass**
die Spannungsdifferenz der gemessenen Zellspannung (Uₘₑₛ) und der berechneten Zellspannung (U_{rec}) vor der Multiplikation mit dem Verstärkungsfaktor tiefpassgefiltert wird.

4. Verfahren nach einem der Ansprüche 1 bis 3,
**dadurch gekennzeichnet, dass**
das Zellmodell (6) zur Berechnung der Zellspannung (U_{rec}) jeweils einen Term (3-1, 3-3, 3-2) für die Überspannung, die Hysteresespannung und die Leerlaufspannung berücksichtigt.

5. Verfahren nach einem der Ansprüche 1 bis 4,
**dadurch gekennzeichnet, dass**
der Verstärkungsfaktor in Abhängigkeit folgender vier Terme (6-1, 6-2, 6-3, 6-4) bestimmt wird:
- ein Grundverstärkungsterm;
- ein Batteriestromvorzeichenterm;
- ein Potenzterm des Absolutwerts des Zellstroms; und
- ein exponentieller Abklingterm.

6. Batteriezellenüberwachungsvorrichtung (8), umfassend Erfassungsmittel zum Erfassen des von wenigstens einer Zelle (1) einer Sekundärbatterie (2) abgebbaren Stroms, der Klemmspannung und einer Batterietemperatur sowie einen Datenspeicher und eine Recheneinheit (3),
**dadurch gekennzeichnet, dass**
die Erfassungsmittel, der Datenspeicher und die Recheneinheit (3) zur Ausführung der während der eigentlichen Nutzung der Zelle (1) durchgeführten Verfahrensschritte eines Verfahrens nach einem der Ansprüche 1 bis 5 eingerichtet sind.

7. Verwendung eines Verfahrens nach einem der Ansprüche 1 bis 5,
zur Bestimmung der Lebensdauer von Batteriezellen einer Traktionsbatterie eines Fahrzeugs mit einem zumindest teilelektrifizierten Antriebsstrang, wobei die während der eigentlichen Nutzung der Zelle (1) durchgeführten Verfahrensschritte im Fahrzeug durchgeführt werden.

8. Fahrzeug mit einem zumindest teilelektrifizierten Antriebsstrang, umfassend eine Traktionsbatterie und eine Batteriezellenalterungsbestimmungsvorrichtung **dadurch gekennzeichnet, dass**
die Batteriezellenalterungsbestimmungsvorrichtung eine Batteriezellenüberwachungsvorrichtung (8) nach Anspruch 6 aufweist.

## Claims

1. Method for model-based estimation of the impedance of a galvanic cell (1) of a secondary battery (2) by means of an estimation model (4) executed on a computing unit (3), wherein at least some of the model parameters of an equivalent circuit diagram (5) of the cell (1) are adjusted in a cell model (6) contained in the estimation model (4) over the service life of the cell (1), wherein the equivalent circuit diagram (5) comprises at least one resistance element (R) and one capacitance element (C), **characterized by**
the following method steps carried out before the cell (1) is actually used:
- initially parameterizing the cell model (6) on the basis of series of measurements of electrochemical impedance spectroscopy of an identical cell (1);
- generating a reference database (7) comprising an assignment of model parameter reference values and corresponding impedance reference values over a lifetime map of the identical cell (1), by:
∘ imposing a plurality of temperature-specific charging and discharging profiles, each comprising a voltage curve of the cell (1) over time, on the estimation model (4);
∘ thereby updating the model parameters of the equivalent circuit diagram (5) to be adjusted by means of a non-linear optimizer, wherein a difference between the measured cell voltage (Uₘₑₛ, U_{rec}) calculated by the cell model (6) is formed and minimized, wherein model parameters found in relevant minima are used to form the model parameter reference values; and
∘ calculating the impedance reference values corresponding to the model parameter reference values;
- fitting a relevant model parameter reference value from the reference database (7) by means of a polynomial fit and storing the fitting coefficients determined thereby in a data storage means;
and the following method steps carried out while the cell (1) is actually used:
- determining the difference between a measured cell voltage (Uₘₑₛ) and a cell voltage (U_{rec}) calculated using the cell model (6);
- specifying a gain factor and multiplying the voltage difference determined in the previous step by the gain factor; and
- incrementally ascertaining the impedance of the cell (1), wherein the next increment of the impedance is calculated by adding the current increment of the impedance to the product of the gain factor and the voltage difference calculated in the previous method step, wherein the variable model parameters are then updated to the next increment of the impedance calculated in this way, taking into account the fitting coefficients.

2. Method according to claim 1,
**characterized in that**
the equivalent circuit diagram (5) of the cell (1) contains at least one additional element of the following further elements:
- a ZARC element (ZARC);
- a coil element;
- a finite length Warburg element (FLW); and/or
- a finite space Warburg element (FSW).

3. Method according to claim 1 or claim 2,
**characterized in that**
the voltage difference of the measured cell voltage (Uₘₑₛ) and the calculated cell voltage (U_{rec}) is low-pass filtered before multiplication by the gain factor.

4. Method according to any of claims 1 to 3,
**characterized in that**
the cell model (6) takes into account one term (3-1, 3-3, 3-2) each for the overvoltage, the hysteresis voltage and the open-circuit voltage in order to calculate the cell voltage (U_{rec}).

5. Method according to any of claims 1 to 4,
**characterized in that**
the gain factor is ascertained depending on the following four terms (6-1, 6-2, 6-3, 6-4):
- a basic gain term;
- a battery current sign term;
- a power term of the absolute value of the cell current; and
- an exponential decay term.

6. Battery cell monitoring device (8), comprising detection means for detecting the current that can be output by at least one cell (1) of a secondary battery (2), the terminal voltage and a battery temperature, as well as a data storage means and a computing unit (3),
**characterized in that**
the detection means, the data storage means and the computing unit (3) are designed to perform the method steps of a method according to any of claims 1 to 5 carried out while the cell (1) is actually used.

7. Use of a method according to any of claims 1 to 5, for determining the service life of battery cells of a traction battery of a vehicle having an at least partially electrified drive train, wherein the method steps carried out while the cell (1) is actually used are carried out in the vehicle.

8. Vehicle having an at least partially electrified drive train, the vehicle comprising a traction battery and a device for ascertaining battery cell aging,
**characterized in that**
the device for ascertaining battery cell aging comprises a battery cell monitoring device (8) according to claim 6.

## Revendications

1. Procédé pour l'estimation basée sur un modèle de l'impédance d'une cellule (1) galvanique d'une batterie secondaire (2) au moyen d'un modèle d'estimation (4) exécuté sur une unité de calcul (3), dans lequel au moins certains des paramètres de modèle d'un circuit équivalent (5) de la cellule (1) dans un modèle de cellule (6) contenu dans le modèle d'estimation (4) sont adaptés à la durée de vie de la cellule (1), dans lequel le circuit équivalent (5) comprend au moins un élément formant résistance (R) et un élément capacitif (C),
**caractérisé par**
les étapes de procédé suivantes, effectuées avant l'utilisation réelle de la cellule (1) :
- paramétrage initial du modèle de cellule (6) sur la base de séries de mesures de spectroscopie d'impédance électrochimique d'une cellule (1) identique ;
- création d'une base de données de référence (7), comprenant une association de valeurs de référence de paramètres de modèle et de valeurs de référence d'impédance correspondantes concernant une caractéristique de durée de vie de la cellule (1) identique, par :
∘ application au modèle d'estimation (4) d'une pluralité de profils de charge et de décharge spécifiques à la température, comprenant respectivement une courbe de tension de la cellule (1) en fonction du temps ;
∘ ajustement subséquent des paramètres de modèle à adapter du circuit équivalent (5) au moyen d'un optimiseur non linéaire, dans lequel une différence entre les tensions de cellule (Uₘₑₛ, U_{rec}) mesurée et calculée par le modèle de cellule (6) est formée et minimisée, dans lequel des paramètres de modèle trouvés dans des minima respectifs sont utilisés pour former les valeurs de référence de paramètres de modèle ; et
∘ calcul des valeurs de référence d'impédance correspondant aux valeurs de référence de paramètres de modèle ;
- ajustement d'une valeur de référence de paramètre de modèle respective à partir de la base de données de référence (7) au moyen d'un ajustement polynomial et mémorisation des coefficients d'ajustement ainsi déterminés dans une mémoire de données ;
ainsi que par les étapes de procédé suivantes, effectuées pendant l'utilisation réelle de la cellule (1) :
- détermination de la différence entre une tension de cellule mesurée (Uₘₑₛ) et une tension de cellule (U_{rec}) calculée au moyen du modèle de cellule (6) ;
- spécification d'un facteur d'amplification et multiplication de la différence de tension déterminée à l'étape de procédé précédente par le facteur d'amplification ; et
- définition incrémentielle de l'impédance de la cellule (1), dans lequel l'incrément suivant de l'impédance est calculé en ajoutant l'incrément actuel de l'impédance au produit du facteur d'amplification et de la différence de tension calculé à l'étape de procédé précédente, dans lequel les paramètres de modèle modifiables sont ensuite amenés à l'incrément suivant de l'impédance ainsi calculé en tenant compte des coefficients d'ajustement.

2. Procédé selon la revendication 1,
**caractérisé en ce que**
le circuit équivalent (5) de la cellule (1) contient au moins un élément supplémentaire parmi les éléments supplémentaires suivants :
- un élément ZARC (ZARC) ;
- un élément formant bobine ;
- un élément de Warburg de longueur finie (FLW) ; et/ou
- un élément de Warburg d'espace fini (FSW).

3. Procédé selon la revendication 1 ou 2,
**caractérisé en ce que**
la différence de tension entre la tension de cellule mesurée (Uₘₑₛ) et la tension de cellule calculée (U_{rec}) est filtrée par filtre passe-bas avant d'être multipliée par le facteur d'amplification.

4. Procédé selon l'une des revendications 1 à 3,
**caractérisé en ce que**
le modèle de cellule (6) prend en compte, pour le calcul de la tension de cellule (U_{rec}), respectivement un terme (3-1, 3-3, 3-2) pour la surtension, la tension d'hystérésis et la tension à vide.

5. Procédé selon l'une des revendications 1 à 4,
**caractérisé en ce que**
le facteur d'amplification est défini en fonction des quatre termes (6-1,6-2, 6-3, 6-4) suivants :
- un terme de renforcement de base ;
- un terme de référence de courant de batterie ;
- un terme de puissance de la valeur absolue du courant de cellule ; et
- un terme de décroissance exponentielle.

6. Dispositif de surveillance de cellules de batterie (8), comprenant des moyens de détection permettant de détecter le courant pouvant être fourni par au moins une cellule (1) d'une batterie secondaire (2), la tension aux bornes et une température de batterie, ainsi qu'une mémoire de données et une unité de calcul (3),
**caractérisé en ce que**
les moyens de détection, la mémoire de données et l'unité de calcul (3) sont configurés pour exécuter les étapes de procédé d'un procédé selon l'une des revendications 1 à 5, effectuées pendant l'utilisation réelle de la cellule (1).

7. Utilisation d'un procédé selon l'une des revendications 1 à 5, pour définir la durée de vie de cellules de batterie d'une batterie de traction d'un véhicule comportant une chaîne cinématique au moins partiellement électrifiée, dans laquelle les étapes de procédé effectuées pendant l'utilisation réelle de la cellule (1) sont effectuées dans le véhicule.

8. Véhicule comportant une chaîne cinématique au moins partiellement électrifiée, comprenant une batterie de traction et un dispositif de définition du vieillissement des cellules de batterie
**caractérisé en ce que**
le dispositif de définition du vieillissement des cellules de batterie présente un dispositif de surveillance de cellules de batterie (8) selon la revendication 6.
